(19) Europäisches Patentamt
European Patent Office
Office européen des brevets

(11) EP 3 170 921 A1

(12) EUROPEAN PATENT APPLICATION

(43) Date of publication:
24.05.2017 Bulletin 2017/21

(51) Int Cl.:
C25B 11/03 (2006.01)    C25B 11/04 (2006.01)
C25B 1/04 (2006.01)

(21) Application number: 15195667.9

(22) Date of filing: 20.11.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(71) Applicant: INL - International Iberian
Nanotechnology
Laboratory
4715-330 Braga (PT)

(72) Inventors:
• WANG, Xiaohuang
  4715-330 Braga (PT)
• LIU, Lifeng
  4715-330 Braga (PT)

(74) Representative: Awapatent AB
P.O. Box 1066
251 10 Helsingborg (SE)

(54) ELECTRODE MATERIAL

(57) The present invention relates to a self supporting electrode material suitable for hydrogen and oxygen evolution reactions. The self supporting electrode material comprises a porous core material and a coating material, wherein the porous core material comprises carbon, and the coating material comprises transition metal phosphide. The present invention further relates to a system for water electrolysis, and a method for manufacturing a self supporting electrode material.

Fig.1

## Description

Field of invention

The present invention relates to a self supporting electrode material suitable for hydrogen and oxygen evolution reactions. The present invention further relates to a system for water electrolysis, and to a method for manufacturing a self supporting electrode material.

Background

Water electrolysis has been proposed as the cleanest way to produce hydrogen, if the required electricity is derived from renewable energy sources such as solar or wind. However, the global hydrogen production is only 4% from water electrolysis, primarily because the hydrogen produced by water electrolysis is not economically competitive with that produced by steam reforming of natural gas. Presently, platinum (Pt) and noble metal oxides including ruthenium oxide ($RuO_2$) and iridium oxide ($IrO_2$) are the state-of-the-art electrocatalysts to drive hydrogen evolution and oxygen evolution reactions (HER and OER). Such electrocatalysts suffer from disadvantages including high costs and limited availability of the metals in the earth's crust.

Catalysts manufactured from transition metal sulfides, selenides, carbides, borides, and nitrides have been reported used for HER, and transition metal oxides, hydroxides, and phosphates have been reported used for OER. None of these catalysts has been reported for both HER and OER.

There is a need for materials for electrodes for water electrolysis which provide efficient electrolysis of water, are affordable, and/or are manufactured from abundant materials. Further, there is a need for materials for electrodes for water electrolysis which material and electrodes are able to drive both HER and OER in the same device.

Summary of invention

An object of the present invention is to provide an efficient electrode material suitable for hydrogen and oxygen evolution reactions without disadvantages of prior art.

A further object is to provide for efficient hydrogen and oxygen evolution reactions.

According to a first aspect, there is provided a self supporting electrode material suitable for hydrogen and oxygen evolution reactions. The self supporting electrode material comprises a porous core material and a coating material, wherein the porous core material comprises carbon, and the coating material comprises transition metal phosphide.

The self supporting electrode material provides for efficient provision of electrodes.

The porous core material provides for efficient provision of a porous electrode enabling efficient hydrogen and oxygen production. Further, the porous core material provides for a large surface to volume ratio, high electrical conductivity, and an efficient support for the coating material.

The core material comprising carbon provides for an efficient electrode material which is made from abundant material. Such a core material is durable. The carbon is inert and provides for high resistance to corrosion and oxidation and provides for efficient electron transport. The core material comprising carbon therefore enables high efficiency electrode materials suitable for both cathodes and anodes, and the catalysis of both HER and OER.

The coating material comprising transition metal phosphide, enables efficient electrode material to be manufactured from abundant material.

The transition metal phosphide provides for small free energy for hydrogen adsorption on the transition metal phosphide, which enables efficient catalysis of HER. Further, the transition metal phosphide has strong affinity toward hydroxylation, which provides for efficient OER.

The electrode material comprising the core material comprising carbon and the coating material comprising transition metal phosphide provides for efficient electrode material suitable for both hydrogen and oxygen evolution reactions.

The porous core material comprising carbon may have a maximum average pore size of 1 mm or below, for example 100 micrometers or below, 20 micrometers or below, or 10 micrometers or below, according to scanning electron microscopy measurements. Such average pore sizes provides for efficient electrode materials having a high surface-to-volume ratio.

The transition metal phosphide may be in the form of nanoparticles or nanostructures having an extent in the range of 5 to 500 nm, such as, for example, 10 to 100 nm, along at least one longitudinal axis.

The nanoparticles may be compact or elongated nanoparticles. The compact nanoparticles may refer to nanoparticles wherein the extension in any one direction is not larger than three times the extension in any other direction. Such compact nanoparticles comprise for examples spherical, and cubical nanoparticles, but also comprise nanoparticles having irregular shapes, disk shapes, and parallelepipedic shapes.

The nanoparticles or nanostructures may be selected from the group consisting of compact nanoparticles, spherical nanoparticles, nanorods, nanowires, nanotubes, nanosheets and nanoflowers, or combinations thereof.

The porous core material may be provided in the form of a foam, a paper or a fabric.

The porous core material may be carbon paper.

The carbon may be elemental carbon.

The transition metal may be selected from, the group consisting of nickel, cobalt, iron, copper, molybdenum and manganese, or combinations thereof.

The transition metal phosphide may be selected from the group consisting of $Ni_3P$, $Ni_{12}P_5$, $Ni_2P$, $Ni_5P_4$, $NiP_2$, $Ni_{12}P_5$, $Co_2P$, $CoP$, $CoP_2$, $Fe_3P$, $Fe_2P$, $FeP$, $FeP_2$, $Cu_3P$, $CuP$, $CuP_2$, $MoP$, $Mo_2P$, $Mo_3P$, $MoP_2$, $MnP$, $Mn_2P$, and $MnP_2$, or combinations thereof.

The transition metal may be nickel, and the transition metal phosphide may be selected from the group consisting of $Ni_3P$, $Ni_{12}P_5$, $Ni_2P$, $Ni_5P_4$, $NiP_2$, and $Ni_{12}P_5$, or combinations thereof.

According to a second aspect, there is provided a system for water electrolysis comprising two electrodes for use as cathode and anode respectively, wherein each of the two electrodes is formed by the self supporting electrode material according to the first aspect.

Such a system may be used for electrocatalytic generation of hydrogen, or $H_2$, and oxygen, or $O_2$, at the same time.

The system for water electrolysis may further comprise a power source for providing a driving voltage to the two electrodes.

The system may further comprise an electrolysis chamber or vessel arranged for comprising an electrolyte.

The two electrodes may be provided in the same chamber or vessel arranged for comprising electrolyte, or may each be provided in one individual chamber or vessel comprising electrolyte, wherein the individual chambers or vessels may be commuting vessels or chambers.

The two electrodes may be made of identical electrode material.

According to a third aspect, there is provided a method for manufacturing a self supporting electrode material suitable for hydrogen and oxygen evolution reactions, the self supporting electrode material comprises: a porous core material and a coating material, wherein the porous core material comprises carbon, and the coating material comprises transition metal phosphide. The method comprises: forming a transition metal layer on the porous core material, evaporating solid elemental phosphorous by heating, thereby forming a phosphorous vapour, contacting the phosphorous vapour and the transition metal layer on the porous core material, and heat treating, in an inert atmosphere, the contacted elemental phosphorous and the transition metal layer on the porous core material to a temperature in the temperature range of 300 to 900°C, thereby reacting at least a part of the phosphorous and at least a part of the transition metal under formation of transition metal phosphide on the surface of the porous core material, thereby forming the self supporting electrode material.

The contacting the phosphorous vapour and the transition metal layer on the porous core material provides for efficient contacting and, further, efficient reaction between elemental phosphorous and the transition metal.

The heat treating, in an inert atmosphere, the contacted elemental phosphorous and the transition metal layer on the porous core material to a temperature in the temperature range of 300 to 900°C lends the electrode material efficient properties, for example a large surface-volume-ratio. The temperature range of 300 to 900°C further provides for efficient reaction, and efficient formation of transition metal phosphide in the form of nanostructures.

The nanostructures may comprise nanoparticles having an extent in the range of 5 to 500 nm such as, for example, 10 to 100 nm, along at least one longitudinal axis.

The transition metal layer may be a layer comprising metallic transition metal or transition metal oxide, or combinations thereof. With the method, metallic transition metal and/or transition metal oxide may efficiently be reacted with the phosphorous.

The heat treating may be in a temperature range of 400 to 600°C, such as 450 to 550°C, or 475 to 525°C. Particularly nanostructures comprising nano-sheets or nano-flakes may be obtained in the temperature ranges of 400 to 600°C. Such nano-sheets or nano-flakes provides for very efficient electrode materials.

The forming a transition metal layer on the porous core material may be electro-deposition of the transition metal on the core material.

The evaporating may be by heating to a temperature in the range of 200 to 600°C.

The inert atmosphere may be provided by an inert gas, preferably Ar or $N_2$.

The contacting may be by flowing the phosphorous vapour by a stream of inert gas such that the phosphorous vapour is brought in contact with the transition metal.

The heat treating may be separated in a first heating period having a first temperature during a first time interval and a second heating period having a second temperature during a second time interval.

According to an additional aspect, there is provided a method comprising phosphorization by providing solid phosphorous, such as by means of a paste or powder comprising phosphorous, directly on the porous core material, as one alternative to the described phosphor vapour contacting.

Further features of, and advantages with, the present invention will become apparent when studying the appended claims and the following description. The skilled person will realise that different features of the present invention may be combined to create embodiments other than those described in the following, without departing from the scope of the present invention. Features of one aspect may be relevant to anyone of the other aspects, references to these features are hereby made.

Brief description of drawings

Fig.1 is a schematic illustration of an electrode material according to an embodiment.
Fig.2 is a SEM graph of an electrode material according to an embodiment.
Fig.3 is a schematic illustration of a method for manufacturing a self supporting electrode material suitable for hydrogen and oxygen evolution reactions according to an embodiment.
Fig.4 is a schematic illustration of a system for water electrolysis according to an embodiment.
Fig.5a-d are presentations of experimental data obtained with electrode material according to an embodiment.
Fig.6a-d are presentations of experimental data obtained with electrode material according to an embodiment.
Fig.7a-f are presentations of experimental data obtained with electrode material and a system for water electrolysis according to embodiments.

Detailed description

The present invention will now be described more fully hereinafter with reference to the accompanying drawings, in which preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

The electrode material having a core material comprising carbon provides for an efficient electrode material made from abundant materials. The combination of the porous core material comprising carbon, and the coating material comprising transition metal phosphide provides for durable and efficient electrode material showing resistance to corrosion and oxidation and suitable for both cathodes and anodes, and efficient mass transport of reactants/products as well as the release of $H_2/O_2$ gas from the electrode. As one result the electrode material may be used for both HER and OER. The transition metal phosphide provides for small free energy for hydrogen adsorption on the transition metal phosphide, which enables efficient catalysis of HER. Further, the transition metal phosphide has strong affinity toward hydroxylation, which provides for efficient OER. Such electrode material not only makes it possible to perform both efficient HER and efficient OER, but to perform it in one vessel or in one electrolyzer.

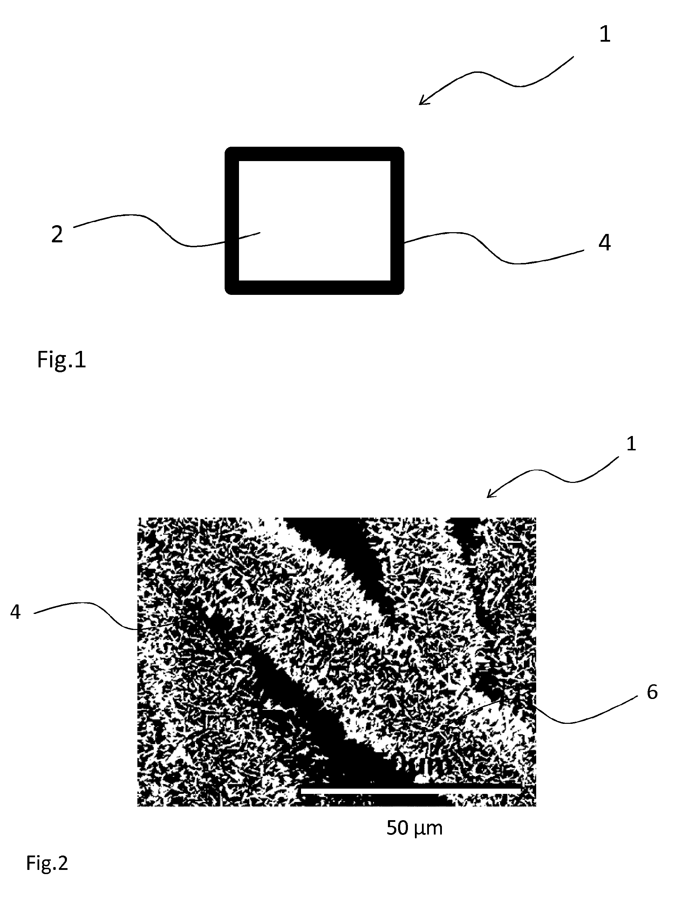

With reference to figure 1, a self supporting electrode material 1 suitable for hydrogen and oxygen evolution reactions according to an embodiment will now be described. The self supporting electrode material 1 comprises a porous core material 2 and a coating material 4, wherein the porous core material 2 comprises carbon, and the coating material 4 comprises transition metal phosphide. It is noted that figure 1 is a schematic representation of the self supporting electrode material 1. For example, the porous structure of the core material 2 is not visualised in figure1. It is realised, that the coating material 4 may be coating also internal pores of the porous core material 2, although the coating 4 of schematic figure 1 is visualised on the outer surface only of the core material 2.

With reference to figure 2, a self supporting electrode material 1 according to an embodiment will now be discussed. The self supporting electrode material 1 comprises a porous core material with a maximum average pore size of 1 mm or below comprising carbon. According to this embodiment, the porous core material comprising carbon is in the form of carbon paper consisting of >99.0% carbon. The porous core material is coated with transition metal phosphide, which according to this embodiment is nickel phosphide. It is evident from figure 2 that the nickel phosphide of this embodiment essentially is in the form of sheets being described as nanosheets, which nanosheets are having an extent in the range of 5 to 500 nm along at least one longitudinal axis, in this example being the thickness of the nanosheets. Although, the porous core material is obscured from view in figure 2 due to the coating material 4, the structure of the porous core material is indicated in and may be understood from figure 2. The porous core material comprises the cylindrically shaped carbon structures 6 which partially are illustrated in figure 2.

Transition metal of the coating material may be selected from the group consisting of nickel, cobalt, iron, copper, molybdenum and manganese, or combinations thereof. The transition metal phosphide may be selected from the group consisting of $Ni_3P$, $Ni_{12}P_5$, $Ni_2P$, $Ni_5P_4$, $NiP_2$, $Ni_{12}P_5$, $Co_2P$, $CoP$, $CoP_2$, $Fe_3P$, $Fe_2P$, $FeP$, $FeP_2$, $Cu_3P$, $CuP$, $CuP_2$, $MoP$, $Mo_2P$, $Mo_3P$, $MoP_2$, $MnP$, $Mn_2P$, and $MnP_2$, or combinations thereof. In the embodiment illustrated in figure 2, the transition metal is nickel and the transition metal phosphide comprises to a major part $Ni_5P_4$ and to a minor part $Ni_2P$ and $NiP_2$. The transition metal phosphide may be nickel phosphide, and the nickel phosphide may be comprised of 80% or more of $Ni_5P_4$ and 20% or less of $Ni_2P$ and/or $NiP_2$.

The nanoparticles may be selected from the group consisting of spherical nanoparticles, nanorods, nanowires, nanosheets, nanotubes, and nanoflowers, or combinations thereof.

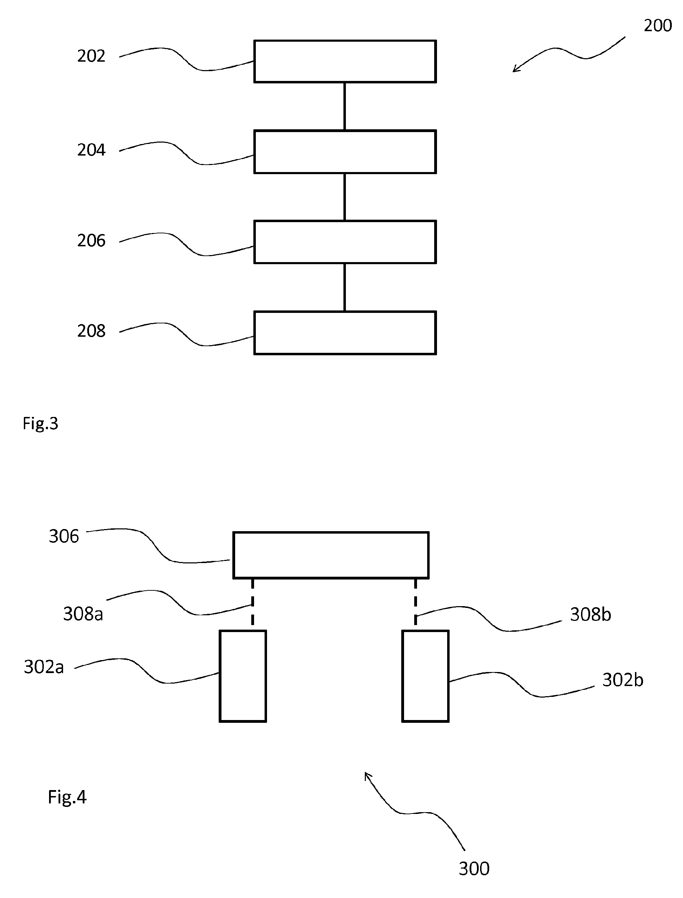

With reference to figure 3, a method 200 for manufacturing a self supporting electrode material 1 suitable for hydrogen and oxygen evolution reactions according to an embodiment will now be discussed. Although not illustrated in figure 3, the self supporting electrode material 1 used with the method 200 comprises a porous core material 2 and a coating material 4, wherein the porous core material 2 comprises carbon, and the coating material 4 comprises transition metal phosphide. The method 200 comprises: forming 202 a transition metal layer on the porous core material 2; evaporating 204 solid elemental phosphorous by heating, thereby forming a phosphorous vapour; contacting 206 the phosphorous vapour and the transition metal layer on the porous core material 2; and heat treating 208, in an inert atmosphere, the contacted elemental phosphorous and the transition metal layer 4 on the porous core material 2 to a temperature in the temperature range of 300 to 900°C, thereby reacting at least a part of the phosphorous and at least a part of the transition metal under formation of transition metal phosphide on the surface of the porous core material 2, thereby forming the self supporting electrode material 1.

It is realised that the self supporting electrode material may be used for manufacturing of electrodes, such as cathodes, or the material may be use directly as electrodes.

An efficient method for manufacturing of a porous electrode is thereby provided. Moreover, the direct phosphorization of the transition metal on the porous core material offers a simple and straightforward approach to manufacturing self-supported low-cost electrodes that may be used as HER and/or OER electrodes. The method is moreover scalable and thereby cost-effective.

The nickel phosphide will form through a direct redox reaction between Ni metal and solid or gaseous P species, for instance, $12Ni + 5P = Ni_{12}P_5$, $2Ni + P = Ni_2P$, $5Ni + 4P = Ni_5P_4$. The driving force of the reaction is the transfer of electrons from the electropositive Ni metal to the electronegative P.

With reference to figure 4, a system 300 for water electrolysis will now be described. The system comprises two electrodes 302a,302b for use as cathode and anode respectively, wherein each of the two electrodes 302a,302b is formed by the self supporting electrode material described with reference to the first and the second aspects and with reference to figures 1 to 3. Each of the electrodes 302a,302b are adapted to be connected to a power source 306, as indicated by dotted lines 308a,308b, which may be, for example cables or conductive wires. Thereby, driving voltage may be supplied to the electrodes 302a,302b to facilitate electrolysis of water.

Example - manufacturing of a self supporting electrode material

Manufacturing of self supporting electrode material

A self supporting electrode material suitable for hydrogen and oxygen evolution reactions, was manufactured according to the below description. It will be evident that a self supporting electrode material comprising a porous core material and a coating material, wherein the porous core material comprises carbon, and the coating material comprises transition metal phosphide, efficiently was manufactured, and further that the electrode material is efficient for OER and HER. Room temperature as used herein refers to ambient temperature of approximately 25°C.

A porous core material in the form of Carbon paper obtained from FuelCell Store and divided into 1 cm $\times$ 2 cm pieces was used for the experiments. The pieces of porous core material was treated in a mixture solution of sulfuric acid and nitric acid (v (98% $H_2SO_4$): v (70% $HNO_3$): v ($H_2O$) = 1:1:1) at 60°C for 24 h under vigorous magnetic stirring, whereby oxyl-groups and surface defects on the surface of carbon microfibers were formed, which enables efficient later nucleation and conformal growth of Ni electrodeposits.

Thereafter, a transition metal layer was formed on the porous core material by electrodeposition of Ni using a Watts-type electrolyte consisting of 200 g $L^{-1}$ $NiSO_4 \cdot 6H_2O$ + 40 g $L^{-1}$ $NiCl_2 \cdot 6H_2O$ + 40 g $L^{-1}$ $H_3BO_3$ in a two-electrode configuration at room temperature. A piece of the Carbon paper was used as the working electrode with an area of 1 $\times$ 1 $cm^2$ exposed to the electrolyte, and a piece of Ni foam was used as the counter electrode, which was folded into a U-shape surrounding the working electrode. The deposition was carried out in galvanostatic mode with a constant electroplating current density of 20 mA $cm^{-2}$ for varying durations of 30, 60, 120, 210 min, respectively, using a Keithley 2400 source meter as the power supply. After deposition, the thus obtained nickel layer on the porous core material was thoroughly rinsed with de-ionized water and absolute ethanol repeatedly, followed by drying in air.

Phosphorization treatment followed the forming of the transition metal layer. The porous core material coated with the transition metal was put in a ceramic boat, and approximately 1 g of red phosphor (P, Sigma-Aldrich) was placed 2 cm away at an upstream side of the porous core material. The boat was then put in a tube furnace (Carbolite). The furnace was purged with high-purity nitrogen ($N_2$, 99.999%) at a flow rate of 800 SCCM for 30 min, followed by heated to 500 °C at 5 °C min$^{-1}$, and kept at this temperature for 1 hour. The furnace was then cooled down to 250 °C at 5 °C min$^{-1}$ and maintained at this temperature for 3 hours. Then, the furnace was allowed to cool down to room temperature. This procedure resulted in phosphorization of the nickel layer of the Carbon paper, and thereby forming the self supporting electrode material, which was washed with deionized water, ethanol and acetone, and dried in a $N_2$ flow after having been removed from the furnace. The weight of the sample was measured before and after phosphorization using a high-precision electronic balance (Sartorius CPA225D) in order to calculate the loading mass of the grown nickel phosphide. At least 4 samples prepared under the same conditions were measured and their weights were averaged to minimize the error. The average nickel phosphide mass loading for the electrode material obtained from the nickel coated porous core material subjected to the Ni electro-deposition for 30, 60, 120, and 210 min was 14.2, 25.8, 49.6, and 83.1 mg cm$^{-2}$.

Characterization

The obtained self supporting electrode material was characterized by scanning electron microscopy using a FEI Quanta 650 FEG microscope equipped with INCA 350 energy dispersive X-ray spectrometer (EDX, Oxford Instruments), transmission electron microscopy (TEM), high-resolution TEM (HRTEM), selected-area electron diffraction (SAED) and EDX mapping studies were carried out on a probe-corrected transmission electron microscope operating at 200 kV (FEI Titan ChemiSTEM 80-200), and powder X-ray diffraction (XRD) conducted on a X'Pert PRO diffractometer (PANalytical).

Results and further experiments

The results from the characterization show that the phosphorization resulted in the formation of a highly dense, vertically aligned nanosheet (NS) array that uniformly covers the entire surface of carbon microfibers of the Carbon paper. The NSs were several $\mu$m across and <50 nm thick.

The formed nickel phosphide comprised of 80% or more of $Ni_5P_4$ and 20% or less of $Ni_2P$ and/or $NiP_2$.

Notably, a temperature range of 400 to 600°C, promoted formation of nanosheets of nickel phosphide.

All electrochemical measurements were conducted at room temperature in a three-electrode or two-electrode configuration using a Biologic VMP-3 potentiostat/galvanostat at room temperature. The HER performance was evaluated in 0.5 M $H_2SO_4$ (pH = 0.28) or 1.0 M KOH (pH = 14) solution using the self supporting electrode material as the working electrode, a graphite plate as the counter electrode, and a saturated calomel electrode (SCE) as the reference. For comparison, the HER performance of a bare Carbon paper and commercially available Pt/C catalysts (20% Pt, FuelCell Store) supported on a Ti sheet (loading mass: ca. 0.3 mg cm$^{-2}$) was also measured. Before each HER test, the electrolyte was deaerated by $N_2$ bubbling for 30 min, and the $N_2$ bubbling was then maintained during the measurement. The OER performance was evaluated in the same three-electrode configuration in 1.0 M KOH solution except that a Pt plate was used as the counter electrode. In this case, a bare Carbon paper and commercially available $RuO_2$ powders (99.9%, Alfa Aesar) supported on a Ti sheet (loading mass: 0.5 mg cm$^{-2}$) were employed as reference. The full electrolyzer cell was assembled using two identical electrodes having carbon paper as core material and nickel phosphide as coating material, hereafter, in the results and further experiments, referred to as CP@Ni-P, electrodes and measured in a two-electrode mode in 1.0 M KOH. The SCE electrode was calibrated before each measurement in Ar/$H_2$-saturated 0.5 M $H_2SO_4$ solution using a clean Pt wire as the working electrode. All linear scan voltammograms (LSV) measured in a three-electrode configuration are *iR*-corrected. The correction was done according to the following equation:

$$E_{corr} = E_{mea} - iR_s,$$

where $E_{corr}$ is *iR*-corrected potential, $E_{mea}$ experimentally measured potential, and $R_s$ the equivalent series resistance extracted from the electrochemical impedance spectroscopy (EIS) measurement. Unless otherwise specified, all potentials are reported versus reversible hydrogen electrode (RHE) by converting the potentials measured vs. SCE according to the following formula:

$$E \text{ (RHE)} = E \text{ (SCE)} + 0.241 + 0.059 \text{ pH.}$$

When normalized to the geometric surface area of the electrodes (i.e., 1 cm$^2$), the electrode material which had undergone electro-deposition for 60 or 120 minutes exhibit better catalytic activity than the electrode material which had undergone electro-deposition for 30 or 210 minutes. The electrocatalytic tests that will be presented below were made using 60 minutes electro-deposition, unless otherwise specified.

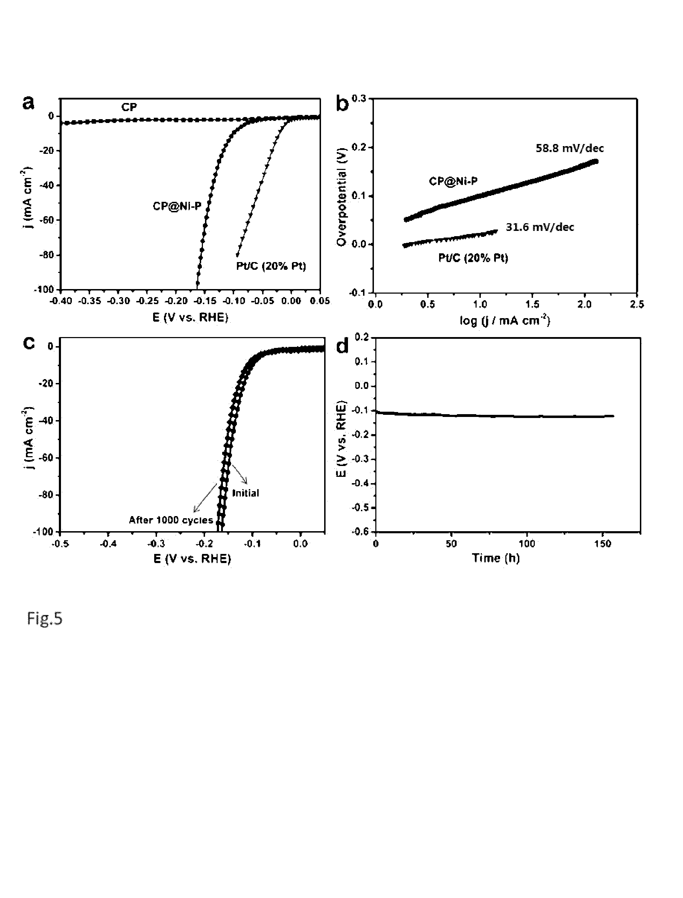

With reference to figure 5a-d, electrocatalytic performance of the electrode material according to embodiments for HER in $N_2$-saturated 0.5 M $H_2SO_4$ will now be discussed. Figure 5a illustrates polarization curves of a bare Carbone paper, Pt/C, and the electrode material according to embodiments. Figure 5b illustrates Tafel plots of Pt/C and the electrode material according to embodiments. Figure 5c illustrates polarization curves of the electrode material according to embodiments recorded before and after 1000 continuous CV cycles in the range of -200 - 60 mV vs. RHE at 50 mV $s^{-1}$. Figure 5d illustrates a chronopotentiostatic curve recorded at -10 mA $cm^{-2}$.

Pt/C exhibits the highest activity for HER, while the bare Carbon paper only shows negligible catalytic current even at a high overpotential (e.g., 300 mV). In contrast, the electrode material according to embodiments has a $\eta_{onset}$ as low as -18 mV. It only needs small over potentials of 98 ($\eta_{10}$), 116 ($\eta_{20}$) and 162 mV ($\eta_{100}$) to drive HER at current densities of 10, 20, and 100 mA $cm^{-2}$, respectively. The electrode material according to embodiments exhibits a Tafel slope of 58.8 mV $dec^{-1}$, which is superior to that of many earth-abundant HER catalysts. As shown in Figure 5c, the polarization curve recorded after 1000 continuous CV cycles slightly deviates from the initial one, and the over potential required to achieve current densities of 20 and 100 mA $cm^{-2}$ merely increases by 9 and 10 mV, respectively, indicative of good stability for the electrode material according to embodiments. The durability test was then performed at a fixed cathodic current density of 10 mA $cm^{-2}$ for ca. 160 h, as illustrated in figure 5d, during which the overpotential was only increased from 98 to 124 mV (ca. 0.16 mV $h^{-1}$), demonstrating excellent long-term durability of the electrode in acid medium.

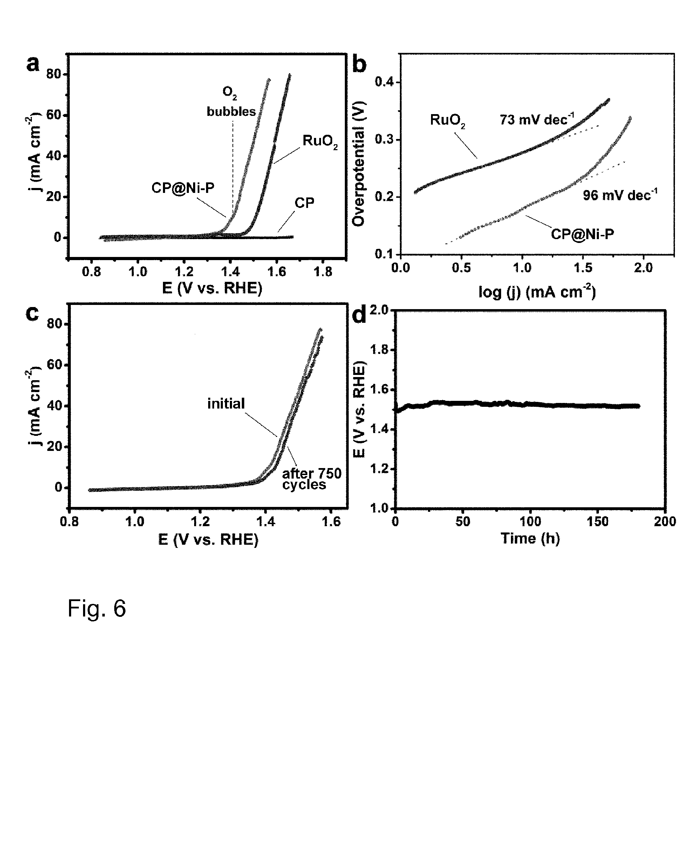

Similar experiments were performed with identical electrodes but in a basic $N_2$-saturated 1.0M KOH solution, which showed even better performance with the electrode material according to embodiments as compared to the experiments discussed with reference to figure 5a-d. With reference to figure 6a-d OER performance of the electrode material according to embodiments in 1.0 M KOH solution, compared with that of a bare Carbon paper and $RuO_2$ nano-powders is illustrated. Before recording the LSV curves, the CP@Ni-P electrode was activated by performing cyclic voltammetric scans between 1.0 and 1.5 V for ca. 200 cycles. The OER performance of the electrode material according to embodiments is found to outperform that of many non-precious OER catalysts, including CoPi, layered double hydroxides, and transition metal phosphides.

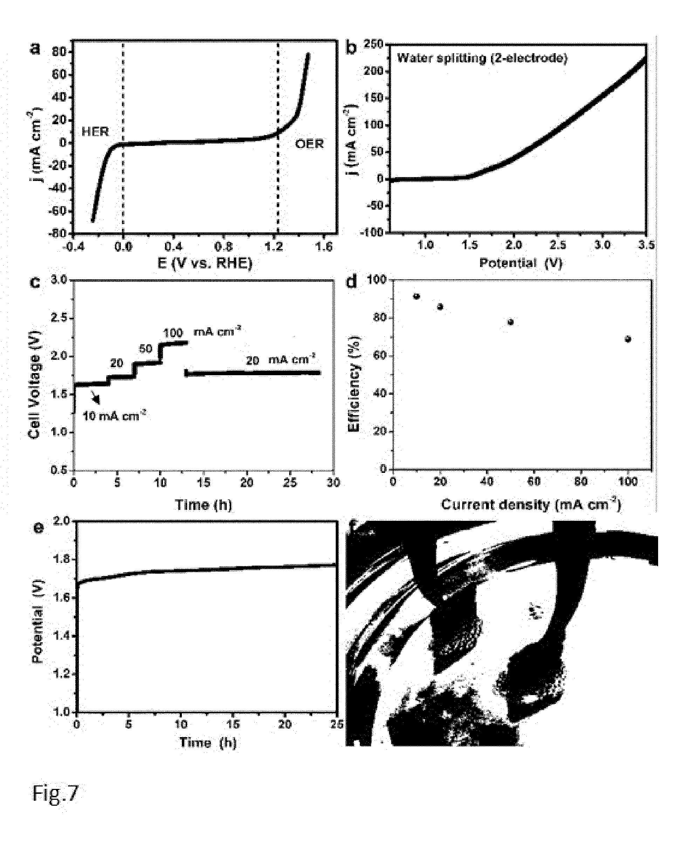

With reference to figure 7a-f the use of the electrode material according to embodiments used both as a cathode for HER and an anode for OER within one vessel is illustrated. Figure 7a illustrates polarization curve recorded in a three-electrode configuration in a wide potential window (-0.24 - 1.47 V vs. RHE) showing the bi-functionality of electrode material toward both HER and OER. Figure 7b illustrates polarization curve recorded at a scan rate of 5 mV $s^{-1}$ in a two-electrode configuration. Figure 7c illustrates Chrono-potentiometric curve of water electrolysis at several different current densities. Figure 7d illustrates energy efficiency of an electrode material according to embodiments-electrolyzer as a function of current density. Figure 7e illustrates long-term durability tests made at 10 and 20 mA $cm^{-2}$. Figure 7f illustrates a digital photograph showing the evolution of $H_2$ and $O_2$ gas from the electrodes at 20 mA $cm^{-2}$. The electrolyte used in all tests was 1.0 M KOH aqueous solution.

With reference to figures 7a-f, it is evident that the self-supported electrode material according to embodiments can serve as both a cathode for HER and an anode for OER, exhibiting a bi-functional characteristic. This bi-functionality is shown more clearly in Figure 7a. In 1.0 M KOH solution, if a cathodic potential is applied (i.e., $E < E^0(H_2/H_2O)$), the electrode shows superior HER activity; while if an anodic potential exceeding the thermodynamic threshold for $O_2$ evolution (i.e., $E > E^0(O_2/H_2O)$) is applied, the electrode according to embodiments will trigger an efficient OER activity. Based on this finding, we have made an alkaline electrolyzer using an electrode comprising the electrode material according to embodiments paired with another identical one. Electrochemical tests in 1.0 M KOH solution reveal that this noble-metal-free water electrolyzer starts to show catalytic current at ca. 1.50 V, as illustrated in figure 7b.

The cell's capability of splitting water was examined at various current densities from 10 to 100 mA $cm^{-2}$ as illustrated in Figure 7c.

The efficiency of electrolysis was calculated by dividing the thermoneutral potential of water electrolysis, i.e., 1.48 V, by the cell's voltage. An efficiency as high as 91% was achieved at 10 mA $cm^{-2}$, which is higher than that of transition metal layered double hydroxides and close to that of $Pt/IrO_2$ electrolyzer measured at the same current density. As the current density increase, an efficiency of 69% is still retained even at 100 mA $cm^{-2}$ (Figure 7d).

Long-term durability of the CP@Ni-P electrolyzer was tested in two-electrode configuration at 10 and 20 mA $cm^{-2}$. A cell voltage of 1.67 V is required to maintain 10 mA $cm^{-2}$, as evident from in Figure 7e.

In summary, the electrode material according to embodiments exhibits superior catalytic performance towards hydrogen evolution reaction in both acidic and basic solutions. Moreover, it also provides outstanding catalytic performance towards oxygen evolution reaction in basic media. The high performance originates, on the one hand, from the high electrocatalytic activity of nickel phosphide for both HER and OER, and on the other hand, from the macroporous nature of the electrode that facilitates the mass transport of reactants/products as well as the release of $H_2/O_2$ gas from the electrode surface. A noble-metal-free alkaline water electrolyzer was manufactured using two identical self-supported electrodes obtained from electrode materials according to embodiments. An electrocatalysis efficiency as high as 91% was achieved at 10 mA $cm^{-2}$. The electrolyzer also shows good durability for at least 24 hours.

**Claims**

1. A self supporting electrode material suitable for hydrogen and oxygen evolution reactions, the self supporting electrode material comprising: a porous core material and a coating material, wherein
the porous core material comprising carbon, and
the coating material comprises transition metal phosphide.

2. The self supporting electrode material according to claim 1, wherein the porous core material comprising carbon has a maximum average pore size of 1 mm or below, preferably 100 micrometers or below, more preferably 20 micrometers or below, most preferably 10 micrometers or below.

3. The self supporting electrode material according to claim 1 or 2, wherein the transition metal phosphide is in the form of nanoparticles having an extent in the range of 5 to 500 nm along at least one longitudinal axis.

4. The self supporting electrode material according to anyone of claims 1- 3, wherein the porous core material is provided in the form of a foam, a paper or a fabric.

5. The self supporting electrode material according to anyone of the claims 1 - 4, wherein the transition metal is nickel, cobalt, iron, copper, molybdenum or manganese.

6. The self supporting electrode material according to anyone of the claims 1 - 5, wherein the transition metal phosphide is selected from the group consisting of $Ni_3P$, $Ni_{12}P_5$, $Ni_2P$, $Ni_5P_4$, $NiP_2$, $Ni_{12}P_5$, $Co_2P$, $CoP$, $CoP_2$, $Fe_3P$, $Fe_2P$, $FeP$, $FeP_2$, $Cu_3P$, $CuP$, $CuP_2$, $MoP$, $Mo_2P$, $Mo_3P$, $MoP_2$, $MnP$, $Mn_2P$, $MnP_2$, and combinations thereof.

7. A system for water electrolysis comprising two electrodes for use as cathode and anode respectively, wherein each of the two electrodes is formed by the self supporting electrode material according to anyone of claims 1 - 6, and wherein each of the electrodes are adapted to be connected to a power source.

8. The system for water electrolysis according to claim 7 further comprising a power source for providing a driving voltage to the two electrodes.

9. A method for manufacturing a self supporting electrode material suitable for hydrogen and oxygen evolution reactions, the self supporting electrode material comprising: a porous core material and a coating material, wherein the porous core material comprises carbon, and the coating material comprises transition metal phosphide, the method comprises:

forming a transition metal layer on the porous core material,
evaporating solid elemental phosphorous by heating, thereby forming a phosphorous vapour,
contacting the phosphorous vapour and the transition metal layer on the porous core material, and
heat treating, in an inert atmosphere, the contacted elemental phosphorous and the transition metal layer on the porous core material to a temperature in the temperature range of 300 to 900°C, thereby reacting at least a part of the phosphorous and at least a part of the transition metal under formation of transition metal phosphide on the surface of the porous core material, thereby forming the self supporting electrode material.

10. The method according to claim 9, wherein the transition metal layer is a layer comprising metallic transition metal or transition metal oxide, or combinations thereof.

11. The method according to claim 9 or 10, where the forming a transition metal layer on the porous core material is electro-deposition of the transition metal on the core material.

12. The method according to anyone of claims 9-11, wherein the evaporating is by heating to a temperature in the range of 200 to 600°C.

13. The method according to anyone of claims 9 - 12, wherein the inert atmosphere is provided by an inert gas, preferably Ar or $N_2$.

14. The method according to anyone of the claims 9 - 13, wherein the contacting is by flowing the phosphorous vapour by a stream of inert gas such that the phosphorous vapour is brought in contact with the transition metal.

15. The method according to anyone of the claims 9 - 14, wherein the heat treating is separated in a first heating period having a first temperature during a first time interval and a second heating period having a second temperature during a second time interval.

1

2                                    4

Fig.1

1

4

6

50 μm

Fig.2

202

204

206

208

200

Fig.3

306

308a

308b

302a

302b

300

Fig.4

Fig.5

Fig. 6

Fig.7

Europäisches
Patentamt

European
Patent Office

Office européen
des brevets

## EUROPEAN SEARCH REPORT

Application Number

EP 15 19 5667

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 104 941 674 A (UNIV SOUTHWEST) 30 September 2015 (2015-09-30) | 1-8 | INV. C25B11/03 C25B11/04 C25B1/04 |
| Y | * abstract * * claims 1,2,10 * * examples 1-3 * * paragraph [0003] * | 9-15 | |
| X | WO 2015/102618 A1 (UNIV RUTGERS [US]) 9 July 2015 (2015-07-09) | 1-8 | |
| Y | * claims 1-3,5,6,8-13,20 * * paragraphs [0006], [0009], [0019], [0020], [0022], [0027], [0028] * | 9-15 | |
| X | DE 32 44 076 A1 (VYTLACIL RICHARD DR) 30 May 1984 (1984-05-30) | 1,5,6 | |
| Y | * claims 4-6,9,10,12 * * page 7, line 1 - page 8, line 4 * | 2-4,7-15 | |
| X | US 2007/298293 A1 (SON IN-HYUK [KR]) 27 December 2007 (2007-12-27) | 1,5,6 | |
| Y | * claim 5 * * examples 1,7,10 * * paragraphs [0024], [0025], [0028], [0029], [0031] * | 2-4,7-15 | TECHNICAL FIELDS SEARCHED (IPC) C25B |
| Y | CN 104 630 822 A (UNIV TAIYUAN TECHNOLOGY) 20 May 2015 (2015-05-20) * abstract * * claims 1-8 * * examples 1, 4-7 * * paragraphs [0008] - [0023] * | 1-15 | |

-/--

The present search report has been drawn up for all claims

| Place of search | Date of completion of the search | Examiner |
|---|---|---|
| Munich | 15 March 2016 | Perednis, Dainius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ZHI-XIONG CAI ET AL: "Electrodeposition-Assisted Synthesis of Ni 2 P Nanosheets on 3D Graphene/Ni Foam Electrode and Its Performance for Electrocatalytic Hydrogen Production", CHEMELECTROCHEM, vol. 2, no. 11, 11 August 2015 (2015-08-11), pages 1665-1671, XP055258327, ISSN: 2196-0216, DOI: 10.1002/celc.201500239 * abstract * * figures 1-5 * *Scheme 1* * page 1666, left-hand column, paragraph 1 - right-hand column, paragraph 2 * * page 1670, right-hand column, paragraph 2 *  ----- | 1-15 | |

| | TECHNICAL FIELDS SEARCHED (IPC) |
|---|---|

The present search report has been drawn up for all claims

| Place of search | Date of completion of the search | Examiner |
|---|---|---|
| Munich | 15 March 2016 | Perednis, Dainius |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................

& : member of the same patent family, corresponding
document

EPO FORM 1503 03.82 (P04C01)

**EP 3 170 921 A1**

## ANNEX TO THE EUROPEAN SEARCH REPORT
## ON EUROPEAN PATENT APPLICATION NO.

EP 15 19 5667

15-03-2016

| Patent document cited in search report | | Publication date | Patent family member(s) | | Publication date |
|---|---|---|---|---|---|
| CN 104941674 | A | 30-09-2015 | NONE | | |
| WO 2015102618 | A1 | 09-07-2015 | NONE | | |
| DE 3244076 | A1 | 30-05-1984 | NONE | | |
| US 2007298293 | A1 | 27-12-2007 | KR 20070098135 A | | 05-10-2007 |
| | | | US 2007298293 A1 | | 27-12-2007 |
| CN 104630822 | A | 20-05-2015 | NONE | | |

EPO FORM P0459

For more details about this annex : see Official Journal of the European Patent Office, No. 12/82